# EUROPEAN PATENT APPLICATION

(11) **EP 4 818 711 A1**
(43) Date of publication of application: **07.10.2026**
(21) Application number: 25305485.2
(22) Date of filing: 01.04.2025
(51) Int. Cl.: G01R 31/26, G01R 31/28

(54) **BIDIRECTIONAL GATE CURRENT INJECTION FOR GATE OXIDE DEGRADATION MONITORING IN POWER SEMICONDUCTORS**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: LASPEYRES, Antoine, 35708 RENNES CEDEX 7 (FR); Quemener, Vincent, 35708 RENNES CEDEX 7 (FR)
(74) Representative: Plasseraud IP

(57) **Abstract**

A monitoring method of a gate oxide degradation in a power semi-conductor module comprising:
- injecting successively two opposite currents into the gate and obtaining a flatband voltage difference ΔV_{FB} between the two gate-to-source voltage shifts of the two injections;
- deducing a degradation level of the gate oxide of the said module.

## Description

### Technical Field

The present disclosure relates to semiconductor technologies, specifically to monitoring gate oxide degradation in power semiconductor devices that can be used during operational service.

### Background Art

Silicon carbide (SiC) metal-oxide-semiconductor field-effect transistors (MOSFETs) are increasingly utilized in power electronic applications due to their excellent performance characteristics. However, reliability issues associated with gate oxide degradation can occur. Known methods for monitoring the health of the gate oxide involve measuring parameters such as threshold voltage, gate leakage current, and drain leakage current. Such known methods require the device to be offline, as they involve voltage sweeps that exceed the threshold voltage and that poses a risk of short circuits. Additionally, these methods are complicated by the presence of device-specific characteristics, such as the Miller effect, which can introduce inaccuracies in the measurements.

A drift phenomenon in SiC devices can occurs, particularly affecting the threshold voltage under certain AC gate stressing conditions. The drift phenomenon is described, for example, in the following documents:
- M. Nagel, S. Race, A. Brandl, I. Kovacevic-Badstuebner and U. Grossner, "Evidence of Dynamic Input Capacitance of SiC Power MOSFETs" 2024 36th International Symposium on Power Semiconductor Devices and ICs (ISPSD), Bremen, Germany, 2024, pp. 128-131, doi: 10.1109/ISPSD59661.2024.10579649; and
- B. Asllani, A. Castellazzi, O. A. Salvado, A. Fayyaz, H. Morel and D. Planson, " VTH-Hysteresis and Interface States Characterisation in SiC Power MOSFETs with Planar and Trench Gate" 2019 IEEE International Reliability Physics Symposium (IRPS), Monterey, CA, USA, 2019, pp. 1-6, doi: 10.1109/IRPS.2019.8720612.

The drift phenomenon can lead to significant deviations from expected performance, impacting the device's input capacitance and overall reliability. Existing monitoring techniques are further challenged by their inability to effectively separate the effects of different types of trapped charges at the SiC-oxide interface. These limitations highlight the need for a more effective and reliable method to monitor gate oxide degradation, one that can be performed without taking the device offline and that can accurately account for the various factors influencing device performance.

### Summary

This disclosure improves the situation.

It is proposed a monitoring method of a gate oxide degradation in a power semi-conductor module comprising the following series of operations:
a. injecting a first current I_{g0} of constant amplitude and a first polarity into a gate of said module during an off state of the module, resulting in a first gate-to-source voltage shift;
b. injecting a second current -I_{g0} having the same amplitude as that of the first current I_{g0} and the opposite polarity of that of the first current I_{g0} into the gate of said module during an off state of the module, resulting in a second gate-to-source voltage shift in the opposite direction of that of the first gate-to-source voltage shift;
c. measuring the gate-to-source voltage V_{GS} at least during the injection of the first current I_{g0} and during the injection of the second current -I_{g0};
d. deducing from the measured gate-to-source voltage V_{GS} respectively a first flatband voltage value V_{FB1} and a second flatband voltage value V_{FB2} corresponding to a slowdown of the gate-to-source voltage shift during the injection respectively of the first current I_{g0} and the second current -I_{g0};
e. calculating a difference between the first flatband voltage value V_{FB1} and the second flatband voltage value V_{FB2} to obtain a flatband voltage difference ΔV_{FB}.

The method further comprises at least one of the following operations to deduce a degradation level of the gate oxide of the said module:
f1. comparing the flatband voltage difference ΔV_{FB} to a predetermined reference value ΔV_{FB,Ref};
f2. comparing the flatband voltage difference ΔV_{FB} to at least one previously calculated value flatband voltage difference ΔV_{FB,N-1} to deduce a degradation level of the gate oxide of the said module;
f3. comparing the absolute value of the first and second currents |I_{g0}|, to a predetermined reference value |I_{g0,Ref}|;
f4. comparing the absolute value of the first and second currents |I_{g0,N}|, to at least one previously absolute value of the first and second currents |I_{g0,N-1}|.

In another aspect, it is proposed a power semi-conductor module comprising a single Metal-Oxide-Semiconductor or a set of Metal-Oxide-Semiconductor elements, said module further comprising:
- gate current injection means, and
- measuring means adapted to measure a gate-to-source voltage V_{GS},
being arranged to implement a method according to the preceding paragraph.

In another aspect, it is proposed a computer software comprising instructions to implement a method as defined here when the software is executed by a processor. In another aspect, it is proposed a computer-readable non-transient recording medium on which a software is registered to implement the method as defined here when the software is executed by a processor.

The following features, can be optionally implemented, separately or in combination one with the others:

The series of operations is repeated at least once so that there are at least a first and a second iteration,
wherein the amplitude of the first current I_{g0} and the second current -I_{g0} is maintained constant from one iteration N-1 to the following one N,
and wherein the flatband voltage differences ΔV_{FB,N-1}, ΔV_{FB,N} are compared to each other to deduce a degradation level evolution of the gate oxide of the said module.

The series of operations is repeated at least once so that there are at least a first and a second iteration,
wherein the amplitude of the first current I_{g0} and the second current -I_{g0} is adjusted from one iteration N-1 to the following one N so that the flatband voltage differences ΔV_{FB,N-1}, ΔV_{FB,N} remain constant, and wherein the absolute value of the first and second currents |I_{g0,N-1}|, |I_{g0,N}| are compared to each other to deduce a degradation level evolution of the gate oxide of the said module.

The method further comprises, before the series of operations, the following preliminary calibration steps:
- injecting a constant reference current I_{g,Ref} into a gate of said module during an off state of the module, resulting in a first gate-to-source voltage shift,
- measuring the gate-to-source voltage V_{GS} at least during the injection of said initial current I_{g,ref};
- deducing from the measured gate-to-source voltage V_{GS} a reference flatband voltage value V_{FB,Ref} corresponding to a slowdown of the gate-to-source voltage shift during the injection of the constant reference current I_{g,Ref}.

The said module comprises bidirectional current sources and/or a circuit of Howland source configured to inject, on command, the first current I_{g0}, the second current -I_{g0}, or nothing.

The method further comprises the following operation:
- if the comparison of the flatband voltage difference ΔV_{FB} to a predetermined reference value ΔV_{FB,Ref} or to at least one previously calculated value flatband voltage difference ΔV_{FB,N} results in a relative difference greater than a pre-established threshold, generating an alert signal, and/or
- if the comparison of the absolute value of the first and second currents |I_{g0}|, to a predetermined reference value |Ig_{0,Ref}| or to at least one previously absolute value of the first and second currents |Ig_{0,N-1}| results in a relative difference greater than a pre-established threshold, generating an alert signal.

The module further comprises shifting gate-to-source voltage means configured to enable to set, on command, the value V_{GS,OFF} of the gate voltage at the off state of the module to a value which is strictly different from the value of the flatband voltage V_{FB} of the module.

### Brief Description of Drawings

Other features, details and advantages will be shown in the following detailed description and on the figures, on which:
**Fig. 1**

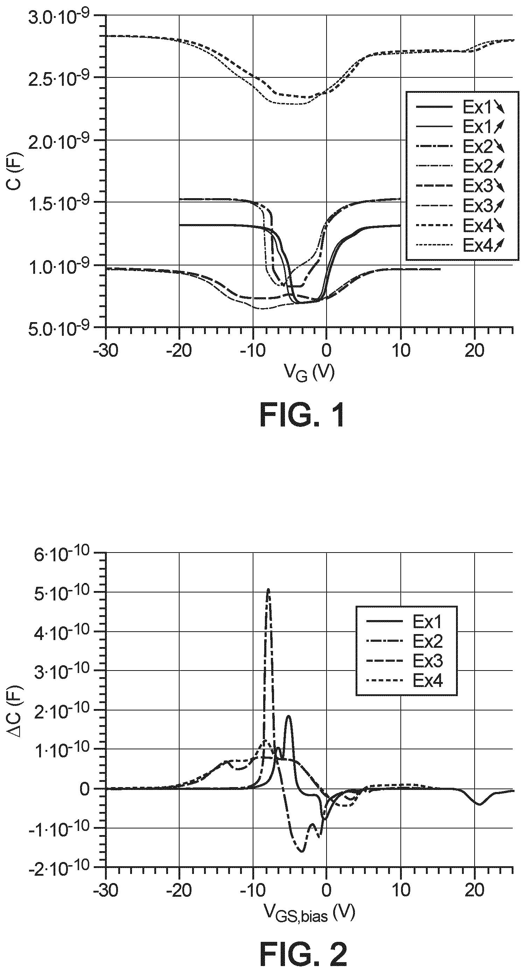

   [Fig. 1] is a graphic representing the Capacitance measured in function of the Gate-to-Source voltage of four commercial MOSFETs under two opposite fast gate voltage sweeps.
**Fig. 2**
   [Fig. 2] is a graphic representing the difference in the Capacitance measurements between the two opposite fast sweeps in function of the Gate-to-Source voltage of the same four commercial MOSFETs as in [Fig. 1].
**Fig. 3**

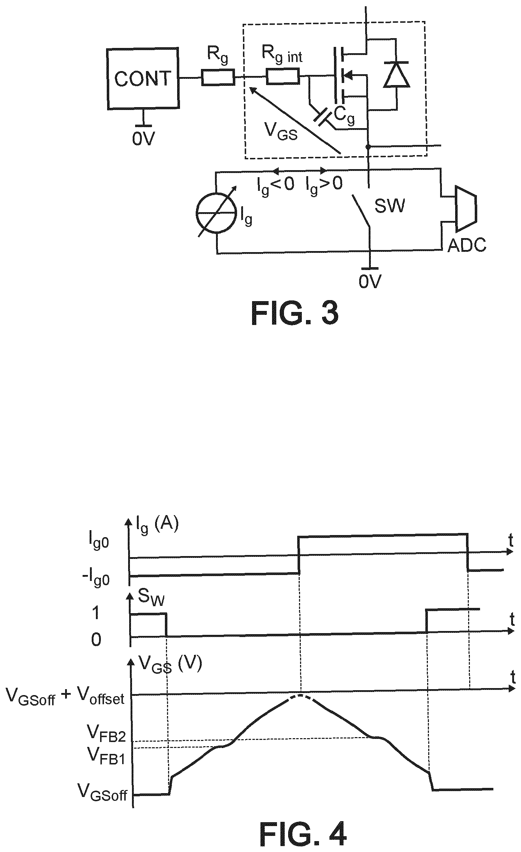

   [Fig. 3] is an electronic diagram of a module according to one embodiment.
**Fig. 4**
   [Fig. 4] is a synchronized triple graph representing the electronic behavior of a module according to an embodiment during the implementation of a method according to an embodiment.
**Fig. 5**

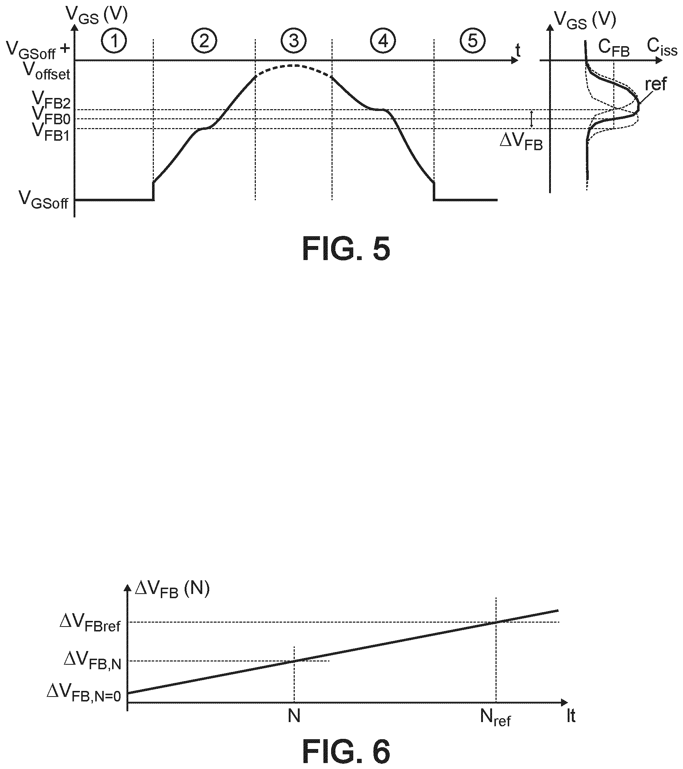

   [Fig. 5] is a double graph representing the Gate-to-Source voltage respectively in function of the time and in function the Capacitance of a module according to an embodiment during the implementation of a method according to an embodiment.
**Fig. 6**
   [Fig. 6] is a graphic representing the Difference between two measured flatband voltages of a module according to an embodiment in function of its age (long time).
**Fig. 7**

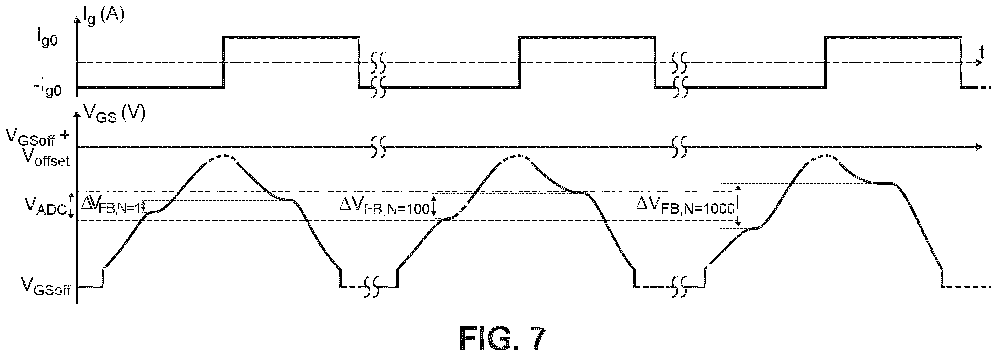

   [Fig. 7] is a synchronized double graph representing the electronic behavior of a module according to an embodiment during the implementation of a method according to an embodiment.
**Fig. 8**

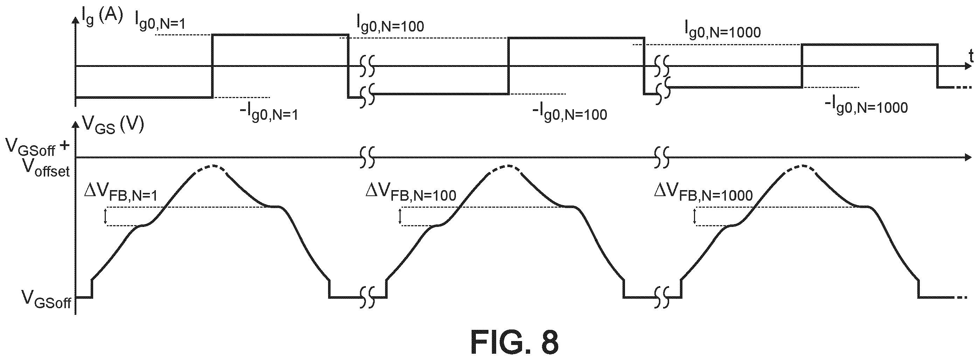

   [Fig. 8] is a synchronized double graph representing the electronic behavior of a module according to an embodiment during the implementation of a method according to an embodiment.
**Fig. 9**

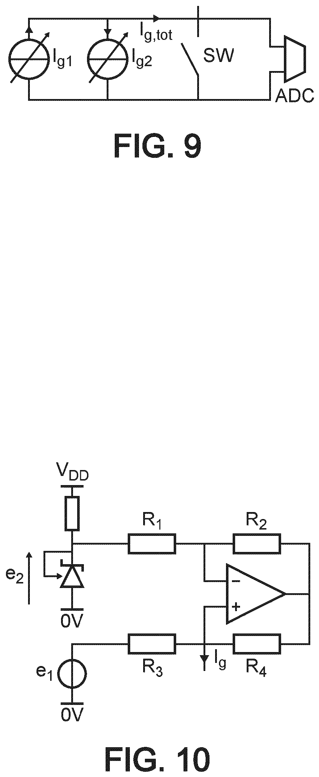

   [Fig. 9] is an electronic diagram of an example of a gate current injection means that can be used as a part of a module according to one embodiment for the implementation of a method according to an embodiment.
**Fig. 10**
   [Fig. 10] is an electronic diagram of an example of a gate current injection means that can be used as a part of a module according to one embodiment for the implementation of a method according to an embodiment.

### Experimental observations

It is now referred to figures 1 and 2, based on figures of the second documents above cited. In Silicon carbide (SiC) metal-oxide-semiconductor field-effect transistors (MOSFETs), a drift phenomenon of the SiC devices on the threshold voltage ΔVₜₕ has been shown. Under certain AC gate stressing conditions parameters, the threshold voltage ΔVₜₕ increase may exceed typical values observed after standard DC gate stressing. This new phenomenon is attributed to the presence of defects at SiC-oxide interface acting as charge traps. When the Metal-oxide semiconductor is in equilibrium in the accumulation and inversion regions, voltage applied V can be expressed as in the following equation [Math. 1]: $V = φ + \frac{{Q}_{S}}{{C}_{ox}} + \frac{{Q}_{IT}}{{C}_{ox}}$ Where φ is the surface potential, Q_{S} is the net charge of the channel, Q_{IT} is the charge trapped at the interface and Cₒₓ is the maximum capacitance.

Depending on the sweep step amplitude and direction (up or down), dV/dt can be expressed as in the following equation [Math. 2]: $\frac{dV}{dt} = \frac{dφ}{dt} + \frac{1}{{C}_{ox}} . \frac{{dQ}_{S}}{dt} + \frac{1}{{C}_{ox}} . \frac{{dQ}_{IT}}{dt}$

[Fig. 1] and [Fig. 2] each shows the effects on the capacitance during a fast sweep voltage in four devices. For each one of the four device, one slope corresponds an up and another slope corresponds to a down sweep. During the rising edge of the positive half of the AC stress cycle, inversion channel electrons get trapped into the oxide border/interface regions while, during the falling edge of the pulse, these captured electrons are injected back into the substrate and holes from accumulated channel and inverted Junction Field Effect Transistor (JFET) start getting captured at the border/interface region. Thus, equation [Math. 2] will have two different forms depending on its sign. As it is explained in the above cited article, both the semiconductor charge and the surface potential do not depend on the time as *dV*/*dt* is very small in normal characterization conditions to yield transient behavior of these quantities, whereas dynamics of the charge trapped at the interface is related to the emission and capture time constants. The difference between the sweep rates from accumulation to inversion and from inversion to accumulation can be expressed as [Math. 3]: ${\left(\frac{dV}{dt}\right)}_{Accu \to Inv} - {\left(\frac{dV}{dt}\right)}_{Inv \to Accu} = {\left(\frac{1}{{C}_{ox}}.\frac{{dQ}_{IT}}{dt}\right)}_{Accu \to Inv} - {\left(\frac{1}{{C}_{ox}}.\frac{{dQ}_{IT}}{dt}\right)}_{Inv \to Accu}$

If both sweeps are done at constant and equal step, the equation [Math. 3] can be simplified as the following equation [Math. 4]: ${ΔC}_{iss} . \frac{dV}{dt} = {\left(\frac{{dQ}_{IT}}{dt}\right)}_{Accu \to Inv} - {\left(\frac{{dQ}_{IT}}{dt}\right)}_{Inv \to Accu} = {i}_{e , p} + {i}_{e , n}$ Where i_{e,p} is a current resulting from emissions of holes and i_{e,n} is a current resulting from emission of electrons. Gate oxide degradation generates two primary types of charges, oxide trapped charges Q_{OT} within gate oxide, and interface trapped charges Q_{IT} at the oxide-silicon interface.

### Description of Embodiments

A first embodiment of a method to monitor defects in a power semi-conductor module will be described with reference to figures 3, 4 and 5. The defects results from gate oxide degradation.

Figure 3 shows a Source-to-Gate bidirectional current injection circuit, including the current source I_{g}, a switch SW and an Analog to Digital Converter ADC. As it can be seen on Figure 3, during the method, the absolute value of the DC current source |I_{g}| is constant. Only its sign, positive or negative, is changed. In the equivalent circuit shown on figure 3, the gate-to-source voltage is referenced V_{GS}. The gate capacitance is referenced C_{g} and the gate resistance is the sum of an internal resistance R_{g,int} and an external resistance R_{g}.

Figure 4 shows the evolution of the gate current I_{g}, the Gate-to-Source voltage V_{GS} and the position of the switch SW during the execution of the method. Figure 5 shows the evolution of the gate current I_{g} and the corresponding flat band capacitance C_{FB} of the module.

The method described hereinafter can be executed on a test bench, in the factory, shortly after the module manufacture, for example during qualification tests and prior to its "normal" operational use. The method described hereinafter can be executed during the normal/operational life of the module, including when it is integrated in a larger circuitry.

The following method is executed during an off state of the module: in the initial state, the switch is ON (closed). The power device source connection is clamped at the circuit V_{GSoff} potential. This initial stage corresponds to the part referenced 1 on Figure 5.

The method comprises the following first step:
a. injecting a first current I_{g0} of constant amplitude and a first polarity into a gate of said module during an off state of the module, resulting in a first gate-to-source voltage shift.

In the example of embodiment shown on figures, the injection is triggered by turning off the switch SW (opening it from ON to OFF). The first step corresponds to the part referenced 2 on Figure 5. The first polarity is negative (-) and the second polarity described hereinafter will be positive (+). As a consequence, the first gate-to-source voltage shift is an increase. The current source is set to a negative source-to-emitter current value. In various embodiments of the method, the order of polarities can be opposite: a positive first polarity (+) and then a negative second polarity (-) are injected. In such various embodiments, the direction of shifts are opposed too: the first gate-to-source voltage shift would be a decrease and the second voltage shift would be an increase.

The injection of the first current I_{g0} results in a gate-to-source voltage steep (here increase) at first due to the resistive contribution (R_{g} and R_{g,int}), followed by an almost linear evolution (here increase) due to the input capacitive C_{g} contribution as expressed in the following equation [Math. 5]: ${V}_{GS} \left(t\right) = {I}_{g 0} . \left[\left({R}_{g}+{R}_{g , int}\right)+\frac{t}{{C}_{g} \left({V}_{GS}\right)}\right] + {V}_{GSoff}$

As it can be seen on Figures 4 and 5, after the initial short steep, there is an exception to the linear behavior of the gate-to-source voltage increase. During a short time, the increase of the gate-to-source voltage V_{GS} is slowing down or even stagnating. A plateau is visible on the graph and can be detected and measured. The value of the gate-to-source voltage V_{GS} during such a slowing down is a first flatband voltage value V_{FB1}.

Then, the method comprises the following second step:
b. injecting a second current -I_{g0} having the same amplitude as that of the first current I_{g0} and the opposite polarity of that of the first current I_{g0} into the gate of said module during an off state of the module, resulting in a second gate-to-source voltage shift in the opposite direction of that of the first gate-to-source voltage shift.

Such a second injection is triggered when the gate-to-source value V_{GS} goes past a certain threshold value strictly superior to the first flatband voltage V_{FB1}. In the example of embodiment shown on figures, the second injection is triggered by reversing the direction of the injected current (the polarity of the source). The second step corresponds to the part referenced 4 on Figure 5. The second polarity is positive (contrary to the first one). As a consequence, the second gate-to-source voltage shift is a decrease. The current source is set to a positive source-to-emitter current value. This leads to an inversion of the gate-to-source voltage variation, here from increase to a decrease.

The injection of the second current -I_{g0} results in an almost linear evolution (here decrease) of the gate-to-source voltage due to the input capacitive C_{g} contribution as expressed in the following equation, where V_{offset} represents the gate-to-source voltage increase from its initial value V_{GSoff} due to the first injection, [Math. 6]: ${V}_{GS} \left(t\right) = - {I}_{g 0} . \left[\left({R}_{g}+{R}_{g , int}\right)+\frac{t}{{C}_{g} \left({V}_{GS}\right)}\right] + {V}_{GSoff} + {V}_{offset}$

In the example, when the gate-to-source value V_{GS} goes past a certain threshold value strictly inferior to the second flatband voltage V_{FB2}, the switch SW is turning on again (closing it from OFF to ON) The injection of current -I_{g0} is stopped and it results in a gate-to-source voltage steep (here decrease) due to the resistive contribution (R_{g} and R_{g,int}). This action is made in order to reset the gate-to-source value V_{GS} to its initial value, before the execution of the method. Thus, the module is ready to be used normally/operationally.

As it can be seen on Figures 4 and 5, before the final short steep due to stop of the current injection, there is a (second) exception to the linear behavior of the gate-to-source voltage decrease. During a short time, the decrease of the gate-to-source voltage V_{GS} is slowing down or even stagnating. A plateau is visible on the graph and can be detected and measured. The value of the gate-to-source voltage V_{GS} during such a slowing down is a second flatband voltage value V_{FB2}.

The method comprises the following third step:
c. measuring the gate-to-source voltage V_{GS} at least during the injection of the first current I_{g0} and during the injection of the second current -I_{g0}.

The above first and second steps are made chronologically: the first step, then the second step. The third step (measuring) is carried out at the same time as the first and second steps. The first, second and third steps can be view as a first sequence of the method. Such a first sequence can be performed online during the semiconductor off state. The steps described hereinafter, the fourth and following ones, are described in a logical order because they depend on the third step. They can be view as a second sequence of the method. The second sequence can be carried out in real time, during the current injections and V_{GS} measurement, or *a posteriori* if the measurement results are temporarily stored.

The method comprises the following fourth step:
d. deducing from the measured gate-to-source voltage V_{GS} respectively the first flatband voltage value V_{FB1} and the second flatband voltage value V_{FB2} corresponding to a slowdown (or even a stagnation) of the gate-to-source voltage shift during the injection respectively of the first current I_{g0} and the second current -I_{g0}.

The method comprises the following fifth step:
e. calculating a difference between the first flatband voltage value V_{FB1} and the second flatband voltage value V_{FB2} to obtain a flatband voltage difference ΔV_{FB}.

The obtained flatband voltage difference ΔV_{FB} can be used as a semiconductor degradation indicator, to deduce a degradation level of the gate oxide of the said module. Depending on the context, functions depending on the flatband voltage difference ΔV_{FB} can be calculated (by applying security factor, correction factor, etc.) to obtain a corrected value.

The value of the flatband voltage difference ΔV_{FB}, corrected or not, can be used as an absolute indicator when the method is executed only once or in isolation from any other implementations of the method. According to the tests conducted by the applicant, the value of the flatband voltage difference ΔV_{FB} is particularly useful if it used as a relative indicator when compared to other values. For example, the obtained flatband voltage difference ΔV_{FB} can be compared to at least one reference value ΔV_{FBref} that can be theoretically predetermined of previously measured.

For example, multiple iterations of the method can be executed in analogous modules to compare them. For example, it is possible to execute the method in modules of the same model (theoretically identical but in practice of different qualities) immediately after their manufacture, at the factory, in a quality control context to detect possible production anomalies. If the difference between the obtained flatband voltage difference ΔV_{FB} and a reference value ΔV_{FBref} exceeds a predetermined tolerance threshold, the corresponding module can be discarded from production.

As another example of use as a relative indicator, it is possible to execute the method as a repetitive iterations N in the same module, for example periodically, including during its operational life. According to the first embodiment and when the series of operations "a" to "e" is repeated at least once (there are at least a first and a second iteration), the amplitude of the first current I_{g0} and the second current -I_{g0} is maintained constant from one iteration N-1 to the following one N, and the flatband voltage differences ΔV_{FB,N-1}, ΔV_{FB,N} are compared to each other to deduce a degradation level evolution of the gate oxide of the said module. In such a case, the obtained flatband voltage differences can be compared one to the others, to a reference value ΔV_{FBref} and/or be registred as a historical evolution during the operational life of the module. Such an example is shown on [Fig. 6] and [Fig. 7]: The evolution of the obtained flatband voltage differences is monitored during (a long) time "It" in function its age, from its initial value ΔV_{FB N=0} that can be dependent from module parameters and current injection amplitude. A signal can be generated when its value reaches or exceeds a reference (threshold) value ΔV_{FBref} that is considered as a critical value (risk of failure or poor performance). The degradation of gate oxide can be monitored online and the maintenance can be time specific. The threshold value ΔV_{FBref} can be a "stopping criteria" and can be device scpecific.

In the same way, the prediction of the date of reaching such a critical value can be extrapolated in advance, for example in a context where one wishes to plan preventive maintenance. The ways of using such an indicator are very varied and depend a lot on the context and the corresponding technical needs.

Depending on the context, the method can comprise at least one of the following operations to deduce a degradation level of the gate oxide of the said module:
f1. comparing the flatband voltage difference ΔV_{FB} to a predetermined reference value ΔV_{FB,Ref};
f2. comparing the flatband voltage difference ΔV_{FB} to at least one previously calculated value flatband voltage difference ΔV_{FB,N-1} to deduce a degradation level of the gate oxide of the said module;
f3. comparing the absolute value of the first and second currents |I_{g0}|, to a predetermined reference value |I_{g0,Ref}|;
f4. comparing the absolute value of the first and second currents |I_{g0,N}|, to at least one previously absolute value of the first and second currents |I_{g0,N-1}|.

As above explained, in the example of the first embodiment, after the operation "e", the method can advantageously comprise the above operations "f1" and "f2" comparing the flatband voltage difference ΔV_{FB} to a previous value or to a reference value.

[Fig. 9] shows an example of a dual current sources that can be used to set a bidirectional current source I_{g0} and -I_{g0}. Such a dual current sources use two unidirectional controlled current sources I_{g1} and I_{g2} in anti-parallel. It is a simple implementation to obtain a constant current source amplitude |I_{g0}|. The following [Table 1] contains examples of values of the two sources I_{g1} and I_{g2} to set the injected current I_{g0}. According to the circuit show on [Fig. 9].

**[Table 1]**

| | | |
|---|---|---|
| **I_{g1}** | **I_{g2}** | **I_{gtot}** |
| I_{g0} | I_{g0} | 0 |
| I_{g0} | 2·I_{g0} | -I_{g0} |
| 2·I_{g0} | I_{g0} | I_{g0} |
| 2·I_{g0} | 2·I_{g0} | 0 |

However, other current source circuit, different from such a dual current sources can be used in various first embodiments. For example, a Howland source that will be described hereinafter can be used.

Because of the non-linear dependency of the input capacitive C_{g}(V_{GS}) with the gate-to-source voltage V_{GS} (see [Math. 6]) around the flatband voltages V_{FB}, the gate-to-source voltage V_{GS} slope shows a clear variation when the values of flatband are reaches (V_{GS}=V_{FB1} or V_{GS}=V_{FB2}). The difference of flat band position between positive slope and the negative slope is a signature of the SiC **MOSFET** gate oxide "health" (level of degradation). Thus, measured flatband voltages V_{FB1} and V_{FB2} can be expressed as in the following equations [Math. 7] and [Math. 8]. ${V}_{FB 1} = {V}_{FB 0} \left(T, {I}_{load}, {V}_{DC}\right) + {ΔV}_{FB 1} \left(N, \frac{{dV}_{GS}}{dt}\right)$ ${V}_{FB 2} = {V}_{FB 0} \left(T, {I}_{load}, {V}_{DC}\right) + {ΔV}_{FB 2} \left(N, \frac{{dV}_{GS}}{dt}\right)$

In [Math. 7] and [Math. 8], V_{FB0} is the flatband voltage reference when there is no degradation. This value is temperature (T) and power (I_{load}, V_{DC}) dependent. ΔV_{FB1} and ΔV_{FB2} represent the shift of the measured flatband voltages around its reference value due to the degradation of the SiC MOSFET gate oxide. This value is supposed to be aging (N) dependent and gate-to source voltage V_{GS} slope (dV_{GS}/dt) dependent. Thus, it is possible to extract the aging effect according to the following equation [Math. 9]. ${ΔV}_{FB} \left(N, \frac{{dV}_{GS}}{dt}\right) = {V}_{FB 1} - {V}_{FB 2} = {ΔV}_{FB 1} \left(N, \frac{{dV}_{GS}}{dt}\right) - {ΔV}_{FB 2} \left(N, \frac{{dV}_{GS}}{dt}\right)$

In [Math. 9], ΔV_{FB}(N,dV_{GS}/dt) is measured using the same current amplitude to keep dV_{GS}/dt constant and make ΔV_{FB} only dependent with aging as expressed in the following equation [Math. 10]. Advantageously, ΔV_{FB} can be extracted online and become independent with load conditions. ${ΔV}_{FB} \left(N,\frac{{dV}_{GS}}{dt}=cst\right) = {ΔV}_{FB} \left(N\right) = {ΔV}_{FB , N}$

In the previously described embodiment, it is presumed that the nominal range of the gate-to-source voltage V_{GS} sweep during method [V_{GSoff}; V_{GSoff} + V_{offset}] includes the first and second flatband voltages V_{FB1} and V_{FB2} (in other words, during the gate-to-source voltage V_{GS} variations, the value passes by the values V_{FB1} and V_{FB2}).

In various embodiments, for example if there is an incompatibility between the raw/nominal gate-to-source voltage V_{GS} operating range and the flatband voltages V_{FB1} and V_{FB2} that must be achieved to be recognized/measured, the gate-to-source voltage V_{GS} range can be adjusted. The adjusted value is called a bias voltage V_{bias}. In such a case, the gate-to-source voltage V_{GS} values varies in a controlled range [V_{GSoff} + V_{bias}; V_{GSoff} + V_{bias} + V_{offset}], in such a way the said range includes the flatband voltages values V_{FB1} and V_{FB2}.

The method can be repeated many times (in the same module during time to monitor the evolution and/or in analogous modules to compare them). In the previously described embodiment and variations, it is presumed that the absolute value of the injected current |I_{g0}| is fixed and constant between each iteration of the method. In some context it is true and sufficient: the pairs of flatband voltages V_{FB1} and V_{FB2} can be slightly different from one iteration of the method to another one, but said values are kept in a nominal voltage range sensitivity of the measuring circuitry, including the nominal voltage range sensitivity of the Analog to Digital Converter (ADC) in the example shown on [Fig. 3]. The sensitivity voltage range of the ADC is represented in dotted lines and the reference "V_{ADC}" on [Fig. 7].

In specific contexts, the values of the pairs of flatband voltages V_{FB1} and V_{FB2} can be more different from one iteration of the method to another one. This variation from one iteration to another can be such that certain values of flatband voltages V_{FB1} and V_{FB2} go outside from the nominal voltage range sensitivity of the measuring circuitry. If such a situation arises, the flatband voltage cannot be detected/measured. The risk of such a situation arising may be high, for example, if the method is executed in modules of the same model (theoretically identical but in practice of different qualities): The actual electronical behavior may differ from one copy to another because of the diversity or heterogeneity in manufacturing quality between said copies. In a second contextual example, the risk of such a situation arising may be high if the method is executed multiple times in the same module during a long operational time life: due to the operational degradation, of the same model (theoretically identical but in practice of different qualities): the flatband voltages V_{FB1} and V_{FB2} values may change over time to the point of going outside from the nominal voltage range sensitivity of the measuring circuitry.

To circumvent the risk above explained that depends on the context, a second embodiment of the method will be described. The second embodiment of a method to monitor defects in a power semi-conductor module is described with reference to figures 8, 9 and 10. The second embodiment will be described by comparison to the first one: unless contrary indication, the features, examples effects, and various embodiments are similar in the first and second embodiments.

In the second embodiment, the series of operations "a" to "e" of the first embodiment is repeated at least once so that there are at least a first and a second iteration. The amplitude of the first current I_{g0} and the second current -I_{g0} is adjusted from one iteration N-1 to the following one N so that the flatband voltage differences ΔV_{FB,N-1}, ΔV_{FB,N} remain constant from the first iteration to the second iteration. An example is shown on [Fig. 8] with at least three iterations of the method.

Contrary to the first embodiment, the flatband voltage differences ΔV_{FB} are driven to be constant while the currents I_{g0} variations are monitored and can be used as an indicator in the second embodiment. For two iterations, the values of the first and second currents |I_{g0,N-1}|, |I_{g0,N}| are compared to each other, or monitored over time and compared to a threshold value, to deduce a degradation level evolution of the gate oxide of the said module.

To stabilize the current source amplitude I_{g0} and impose a constant flatband voltage difference ΔV_{FB} between two iterations, several acquisitions can be needed to stabilize and extract I_{g0}. Once the current values I_{g0} have stabilized so that the flatband voltage difference ΔV_{FB} is the same between several iterations, the corresponding current values |I_{g0,0}|, ..., |I_{g0,N}| can be used as an indicator on the same model as the voltage differences ΔV_{FB,0}, ..., ΔV_{FB,N} are in the first embodiment.

In the example of the second embodiment, after the operation "e" the method can advantageously comprise the operations "f3" and "f4" comparing the gate current I_{g0} to a previous value or to a reference value:
f3. comparing the absolute value of the first and second currents |I_{g0}|, to a predetermined reference value |I_{g0,Ref}|;
f4. comparing the absolute value of the first and second currents |I_{g0,N}|, to at least one previously absolute value of the first and second currents |I_{g0,N-1}|.

To stabilize the current values I_{g0}, a bidirectional current source I_{g} with variable amplitude can be implemented. For example, dual current sources or voltage controlled bidirectional current source like "Howland source" can be provided to the module. A Howland source is shown on [Fig. 10]. Such a circuit comprises an operational amplifier, four resistors R₁, R₂, R₃ and R₄, an input voltage referenced "e1" and one voltage reference referenced "e2".

Howland source in/out law is expressed as following equation [Math. 7] ${I}_{g} = \frac{1}{{R}_{3}} \left[{e}_{1}-{e}_{2}\right]$ if condition of the following equation [Math. 8] is respected ${R}_{1} . {R}_{4} = {R}_{2} . {R}_{3}$

Thus, when the input voltage is superior to the voltage reference (e1 > e2), the gate current is positive (I_{g} > 0). On the other hand, when the input voltage is inferior to the voltage reference (e1 < e2), the input voltage is negative (I_{g} < 0). For example, the voltage reference e2 can be set at the half value of the positive voltage supply (V_{DD}/2) and the voltage reference e1 oscillates between the value of the positive voltage supply V_{DD} to set the gate current I_{g} positive and 0V to set the gate current I_{g} negative.

A Howland source provides two advantages, specifically adapted to the second embodiment:
- current source sign can be set freely without using negative voltage input (e1);
- current source amplitude can be freely set by adjusting the voltage difference between the input voltage and the voltage reference (e1-e2).
However, a Howland source can be used in a module according to the first embodiment, and a bidirectional current source I_{g} with variable amplitude different from a Howland source can be used in a module according to the second embodiment.

In various embodiments, especially when a reference value is needed, the method according to any of the first and second embodiments further comprises, before the series of operations "a" to "e", the following preliminary calibration steps:
- injecting a constant reference current I_{g,Ref} into a gate of the module during an off state of the module, resulting in a first gate-to-source voltage shift,
- measuring the gate-to-source voltage V_{GS} at least during the injection of said initial current I_{g,ref};
- deducing from the measured gate-to-source voltage V_{GS} a reference flatband voltage value V_{FB,Ref} corresponding to a slowdown of the gate-to-source voltage shift during the injection of the constant reference current I_{g,Ref}.

Depending on the context, the method can further comprise the following operation:
- if the comparison of the flatband voltage difference ΔV_{FB} to a predetermined reference value ΔV_{FB,Ref} or to at least one previously calculated value flatband voltage difference ΔV_{FB,N} results in a relative difference greater than a pre-established threshold, generating an alert signal,
   and/or
- if the comparison of the absolute value of the first and second currents |I_{g0}|, to a predetermined reference value |Ig_{0,Ref}| or to at least one previously absolute value of the first and second currents |Ig_{0,N-1}| results in a relative difference greater than a pre-established threshold, generating an alert signal.

To facilitate understanding, the present description focused on a methodological approach: the method has been described "step-by-step". Naturally, the subject matter of the present disclosure is also a module by itself, and more specifically a power semi-conductor module comprising a single Metal-Oxide-Semiconductor element/device or a set of Metal-Oxide-Semiconductor elements/devices. The module further comprising gate current injection means, and measuring means adapted to measure a gate-to-source voltage V_{GS}, and being arranged to implement a method as above described.

### Industrial Applicability

The technical solutions presented here can be used to create new power semiconductor modules with integrated solutions to ensure monitoring the condition and health of the gate oxide of MOSFETs which can affect its performance and lifetime.

In the prior arts methods for monitoring degradation, it is required that the gate voltage V_{g} to go higher than the threshold voltage: the monitoring can only be done when the converter is offline to avoid short circuit. Moreover, because of the device Miller capacitance, a drain voltage dependent sharp peak can be observed in the inversion region which makes compensation of the drain source voltage difficult. In addition, measurement is only done from accumulation to inversion region (emission of holes type trapped charges), impact from electron type trapped charges observed with a sweep from inversion to accumulation cannot be compensated. Such limitations do not exist with the present solutions. The present solutions can be executed both in test/experimental conditions and in application (*ex-situ*, *in-situ off-line, in-situ on-line*)*.* This method enables to easily separate the holes type trapped charges impact from the electron type trapped charges impact. Measurement can also be done online without being affected by converter load point.

By generating two opposite current injections a V_{GS} ramp up and a V_{GS} ramp down are measured around device flatband to easily separate the holes type trapped charges impact from the electron type trapped charges impact and observe the device gate capacitance shift in the accumulation region to be voltage independent. Doing this, it becomes possible to anticipate and make reliable the prediction of failures based on the state of degradation and the actual electronic behavior of each module in real conditions rather than based on theoretical situations and values.

This disclosure is not limited to the methods and modules described here, which are only examples. The invention encompasses every alternative that a person skilled in the art would envisage when reading this text.

## Claims

1. A monitoring method of a gate oxide degradation in a power semi-conductor module comprising the following series of operations:
a. injecting a first current I_{g0} of constant amplitude and a first polarity into a gate of said module during an off state of the module, resulting in a first gate-to-source voltage shift;
b. injecting a second current -I_{g0} having the same amplitude as that of the first current I_{g0} and the opposite polarity of that of the first current I_{g0} into the gate of said module during an off state of the module, resulting in a second gate-to-source voltage shift in the opposite direction of that of the first gate-to-source voltage shift;
c. measuring the gate-to-source voltage V_{GS} at least during the injection of the first current I_{g0} and during the injection of the second current -I_{g0};
d. deducing from the measured gate-to-source voltage V_{GS} respectively a first flatband voltage value V_{FB1} and a second flatband voltage value V_{FB2} corresponding to a slowdown of the gate-to-source voltage shift during the injection respectively of the first current I_{g0} and the second current -I_{g0};
e. calculating a difference between the first flatband voltage value V_{FB1} and the second flatband voltage value V_{FB2} to obtain a flatband voltage difference ΔV_{FB};
and at least one of the following operations to deduce a degradation level of the gate oxide of the said module:
f1. comparing the flatband voltage difference ΔV_{FB} to a predetermined reference value ΔV_{FB,Ref};
f2. comparing the flatband voltage difference ΔV_{FB} to at least one previously calculated value flatband voltage difference ΔV_{FB,N-1} to deduce a degradation level of the gate oxide of the said module;
f3. comparing the absolute value of the first and second currents |I_{g0}|, to a predetermined reference value |I_{g0,Ref}|;
f4. comparing the absolute value of the first and second currents |I_{g0,N}|, to at least one previously absolute value of the first and second currents |I_{g0,N-1}|.

2. The method according to claim 1, wherein the series of operations is repeated at least once so that there are at least a first and a second iteration,
wherein the amplitude of the first current I_{g0} and the second current -I_{g0} is maintained constant from one iteration N-1 to the following one N,
and wherein the flatband voltage differences ΔV_{FB,N-1}, ΔV_{FB,N} are compared to each other to deduce a degradation level evolution of the gate oxide of the said module.

3. The method according to claim 1, wherein the series of operations is repeated at least once so that there are at least a first and a second iteration,
wherein the amplitude of the first current I_{g0} and the second current -I_{g0} is adjusted from one iteration N-1 to the following one N so that the flatband voltage differences ΔV_{FB,N-1}, ΔV_{FB,N} remain constant, and wherein the absolute value of the first and second currents |I_{g0,N-1}|, |I_{g0,N}| are compared to each other to deduce a degradation level evolution of the gate oxide of the said module.

4. The method according to one of the preceding claims, further comprising, before the series of operations, the following preliminary calibration steps:
- injecting a constant reference current I_{g,Ref} into a gate of said module during an off state of the module, resulting in a first gate-to-source voltage shift,
- measuring the gate-to-source voltage V_{GS} at least during the injection of said initial current I_{g,ref};
- deducing from the measured gate-to-source voltage V_{GS} a reference flatband voltage value V_{FB,Ref} corresponding to a slowdown of the gate-to-source voltage shift during the injection of the constant reference current I_{g,Ref}.

5. The method according to one of the preceding claims, wherein the said module comprises bidirectional current sources and/or a circuit of Howland source configured to inject, on command, the first current I_{g0}, the second current -I_{g0}, or nothing.

6. The method according to one of the preceding claims, further comprising the following operation:
- if the comparison of the flatband voltage difference ΔV_{FB} to a predetermined reference value ΔV_{FB,Ref} or to at least one previously calculated value flatband voltage difference ΔV_{FB,N} results in a relative difference greater than a pre-established threshold, generating an alert signal,
and/or
- if the comparison of the absolute value of the first and second currents |I_{g0}|, to a predetermined reference value |Ig_{0,Ref}| or to at least one previously absolute value of the first and second currents |Ig_{0,N-1}| results in a relative difference greater than a pre-established threshold, generating an alert signal.

7. A power semi-conductor module comprising a single Metal-Oxide-Semiconductor or a set of Metal-Oxide-Semiconductor elements, said module further comprising:
- gate current injection means, and
- measuring means adapted to measure a gate-to-source voltage V_{GS},
being arranged to implement the method according to one of claims 1 to 6.

8. The module according to claim 7, further comprising shifting gate-to-source voltage means configured to enable to set, on command, the value V_{GS,OFF} of the gate voltage at the off state of the module to a value which is strictly different from the value of the flatband voltage V_{FB} of the module.

9. Computer software comprising instructions to implement the method according to one of claims 1 to 6 when the software is executed by a processor.

10. Computer-readable non-transient recording medium on which a software is registered to implement a method according to one of claims 1 to 6 when the software is executed by a processor.
